# EUROPÄISCHE PATENTANMELDUNG

(11) **EP 1 845 767 A1**
(43) Veröffentlichungstag der Anmeldung: **17.10.2007**
(21) Anmeldenummer: 07101783.4
(22) Anmeldetag: 06.02.2007
(51) Int. Cl.: H05K 13/04

(54) **Bestückautomat zum Bestücken von Substraten mit elektrischen Bauelementen**

(30) Priorität: 11.04.2006 DE 102006017032
(71) Anmelder: SIEMENS AKTIENGESELLSCHAFT, 80333 München (DE)
(72) Erfinder: Conrad, Robert, Dr., 82054 Sauerlach (DE); Plattner, Rudolf, 94501 Aldersbach (DE)

(57) **Zusammenfassung**

Ein Bestückautomat (1) umfasst ein Chassis (2) und eine Positioniereinrichtung (8) für einen Bestückkopf (6), wobei die Positioniereinrichtung (8) einen Positionierarm (9) und eine Stabilisierungsstrebe (10) aufweist, welche in einer Bewegungsrichtung gegenüber dem Chassis (2) bewegbar gelagert sind, sich quer zur Bewegungsrichtung erstrecken und in Bewegungsrichtung beabstandet sind, der Positionierarm (9) und die Stabilisierungsstrebe (10) auf gleichen Seiten jeweils im Bereich eines Endes durch ein Festlager (11) und jeweils im Bereich eines gegenüberliegenden anderen Endes durch ein loses Stützlager (12) gelagert sind, und die Stabilisierungsstrebe (10) und der Positionierarm (9) nur im Bereich ihrer Enden starr miteinander verbunden sind.

## Beschreibung

Die Erfindung betrifft einen Bestückautomaten zum Bestücken von Substraten mit elektrischen Bauelementen, mit einer Positioniereinrichtung, welche einen Positionierarm und eine Stabilisierungsstrebe aufweist.

Aus der Druckschrift DE-10125399-B4 ist ein Bestückautomat bekannt, welcher einen beweglichen Positionierarm für einen Bestückkopf aufweist, wobei der Positionierarm an einem Ende über ein Festlager und am gegenüberliegenden Ende über einen Reibklotz gelagert ist. Der Positionierarm wird auf Seiten des Festlagers mittels eines Linearmotors bewegt. Durch die hohen einseitig wirkenden Beschleunigungskräfte verhält sich der Positionierarm wie ein Biegebalken, wobei es aufgrund der Reibung auf Seiten des Reibklotzes beim Anfahren einer Zielposition zu nicht reproduzierbaren Ungenauigkeiten kommen kann, was sich negativ auf die Bestückgenauigkeit auswirkt. Derartige Ungenauigkeiten können sich auch einstellen, wenn der Positionierarm anstatt des Reibklotzes über ein loses Stützlager, beispielsweise in Form einer Rolle, gelagert ist

Es ist deshalb die Aufgabe der vorliegenden Erfindung, einen Bestückautomaten mit einer höheren Bestückgenauigkeit zu liefern.

Diese Aufgabe wird durch den Bestückautomaten gemäß Anspruch 1 gelöst. Vorteilhafte Ausgestaltungen des Bestückautomaten sind Gegenstand der abhängigen Ansprüche.

Ein Bestückautomat gemäß Anspruch 1 weist ein Chassis und eine Positioniereinrichtung für einen Bestückkopf auf. Die Positioniereinrichtung umfasst einen Positionierarm und eine Stabilisierungsstrebe, welche in einer Bewegungsrichtung gegenüber dem Chassis verschiebbar gelagert sind, sich quer zur Bewegungsrichtung erstrecken und in Bewegungsrichtung beabstandet sind. Der Positionierarm und die Stabilisierungsstrebe sind auf gleichen Seiten jeweils im Bereich eines ihrer Enden durch ein Festlager und jeweils im Bereich eines gegenüberliegenden anderen Endes durch ein loses Stützlager gelagert. Die Stabilisierungsstrebe und der Positionierarm sind dabei nur im Bereich ihrer Enden starr miteinander verbunden. Die Stabilisierungsstrebe, welche als Zug-Druckstab ausgebildet sein kann, verhindert, dass sich der Positionierarm aufgrund einseitig wirkender Beschleunigungskräfte als reiner Biegebalken verhält und unterbindet weitgehend eine Drehung des Stützlagers um das Festlager in einer durch die Bewegungsrichtung und die Erstreckungsrichtung des Positionierarmes definierten Ebene. Anders ausgedrückt, bewirkt die Stabilisierungsstrebe eine zwangsweise Parallelstellung bzw. parallele Ausrichtung des losen Stützlagers und des Festlagers beim Einwirken von Beschleunigungskräften. Durch diese zwangsweise Parallelstellung wird erreicht, dass mittels der Positioniereinrichtung eine Zielposition mit reproduzierbarer Genauigkeit angefahren werden kann. Dadurch werden die Positioniergenauigkeit und die Bestückgenauigkeit des Bestückautomaten deutlich erhöht. Ferner weist sich diese Konstruktion durch eine schlanke Bauweise und durch ein geringes Gewicht aus, was sich positiv auf die Bestückleitung des Bestückautomaten auswirkt.

In einer Ausgestaltung des Bestückautomaten nach Anspruch 2 ist zwischen der Stabilisierungsstrebe und dem Positionierarm ein durchgehender Zwischenraum ausgebildet. Ein erster Bestückkopf und ein zweiter Bestückkopf sind am Positionierarm derart vorgesehen, dass der erste Bestückkopf entlang einer der Stabilisierungsstrebe abgewandte Seite des Positionierarmes verschiebbar gelagert ist und der zweite Bestückkopf entlang einer der Stabilisierungsstrebe zugewandten Seite des Positionierarmes in dem Zwischenraum verschiebbar gelagert ist. Diese Konstruktion erlaubt die Anordnung zweier Bestückköpfe mit relativ geringem Abstand zueinander, was Verfahrwege beim Bestücken verkürzt und somit die Bestückleistung des Bestückautomaten weiter steigert.

Gemäß einer weiteren Ausgestaltung des Bestückautomaten gemäß Anspruch 3 ist die Stabilisierungsstrebe in einer zur Bewegungsrichtung parallelen Frontalansicht bezüglich des Positionierarmes mittig angeordnet. Auf diese Weise kann der bezüglich Anspruchs 1 erläuterte Stabilisierungseffekt am effizientesten erreicht werden.

Im Folgenden wird ein Ausführungsbeispiel eines Bestückautomaten in Verbindung mit den beigefügten Figuren näher erläutert. In den Figuren sind:
Figur 1 eine schematische Darstellung eines Bestückautomaten in der Draufsicht,
Figur 2 eine Seitenansicht des Bestückautomaten entlang der Linie A-A in Figur 1,
Figuren 3A und 3B schematische Ansichten des Positioniersystems zur Darstellung des Stabilisierungseffekts durch die Stabilisierungsstrebe,
Figur 4 eine Darstellung eines herkömmlichen Positioniersystems ohne Stabilisierungsstrebe.

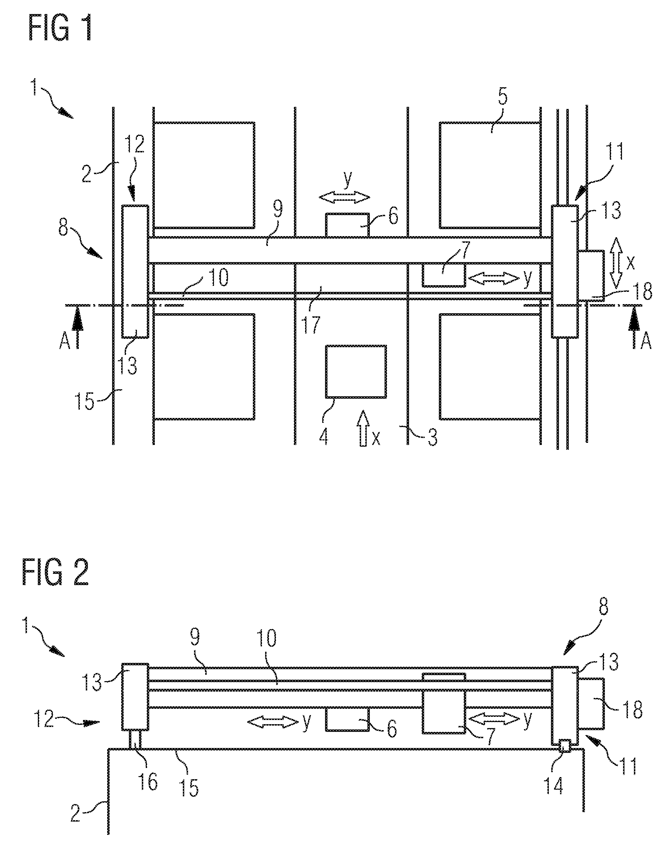

In Figur 1 ist eine schematische Ansicht eines Ausführungsbeispiels des Bestückautomaten 1 in der Draufsicht. Auf einem Chassis 2 des Bestückautomaten 1 ist eine Transportstrecke 3 angeordnet, auf der zu bestückende Substrate 4 in einer Transportrichtung (Pfeil X) zu Bestückpositionen transportiert, dort bestückt und aus dem Bestückautomaten 1 abtransportiert werden. Seitlich der Transportstrecke 3 sind Zuführeinrichtungen 5 für elektrische Bauelemente angeordnet. Der Bestückvorgang wird mittels eines ersten Bestückkopfes 6 und eines zweiten Bestückkopfes 7 durchgeführt, welche mittels einer Positioniereinrichtung 8 in einer zur Bestückebene parallelen Ebene zweidimensional verfahrbar sind.

Die Positioniereinrichtung 8 verfügt über einen Positionierarm 9 und eine Stabilisierungsstrebe 10, welche in einer zur Transportrichtung der Substrate 4 parallelen Bewegungsrichtung (Pfeil X) relativ zum Chassis 2 des Bestückautomaten 1 verfahrbar sind. Der Positionierarm 9 und die Stabilisierungsstrebe 10 erstrecken sich quer zur Bewegungsrichtung und sind in Bewegungsrichtung voneinander beabstandet. Im Ausführungsbeispiel sind der Positionierarm 9 und die Stabilisierungsstrebe 10 parallel zueinander angeordnet, sowohl in der Draufsicht (Fig. 1) als auch in der Frontalansicht (Fig. 2). Der Positionierarm 9 und die Stabilisierungsstrebe 10 sind auf gleichen Seiten jeweils im Bereich eines ihrer Enden über ein Festlager 11 und jeweils auf einem gegenüberliegenden Ende über ein loses Stützlager 12 beweglich gelagert. Das Festlager 11 (in den Figuren 1 und 2 jeweils auf der rechten Seite) ist im Ausführungsbeispiel durch einen Führungswagen 13, an welchem der Positionierarm 9 und die Stabilisierungsstrebe 10 geeignetermaßen befestigt sind (beispielsweise durch Schweißen), und einer am Chassis 2 ausgebildeten Führungsschiene 14, welche mit dem Führungswagen 13 in Eingriff steht, realisiert. Das lose Stützlager 12 (in den Figuren 1 und 2 jeweils auf der linken Seite dargestellt) ist als Führungswagen 13, an welchem der Positionierarm 9 und die Stabilisierungsstrebe 10 befestigt sind, und einer am Chassis 2 ausgebildeten Führungsfläche 15 realisiert, wobei der Führungswagen 13 an seiner der Führungsfläche 15 zugewandten Seite Stützrollen 16 aufweist, welche auf der Führungsfläche 15 abrollen. Der Positionierarm 9 und die Stabilisierungsstrebe 10 sind nur im Bereich ihrer Enden starr miteinander verbunden, so dass zwischen dem Positionierarm 9 und der Stabilisierungsstrebe 10 in Erstreckungsrichtung ein durchgehender Zwischenraum 17 ausgebildet ist.

Der erste Bestückkopf 6 ist an einer der Stabilisierungsstrebe 10 abgewandten Seite des Positionierarmes 9 beweglich (Pfeil Y) gelagert. Der zweite Bestückkopf 7 ist auf einer der Stabilisierungsstrebe 10 zugewandten Seite des Positionierarmes 9 ebenfalls beweglich (Pfeil Y) gelagert.

Bei der Positioniereinrichtung 8 handelt es sich um eine einseitig angetriebene Positioniereinrichtung 8, welche auf Seiten des Festlagers 11 mittels eines geeigneten Antriebs 18, wie beispielsweise einem Linearmotors oder einem Spindelantrieb, angetrieben wird.

Wie anhand der Figur 2 deutlich wird, ist die Stabilisierungsstrebe bezüglich des Positionierarms in einer zur Bewegungsrichtung parallelen Frontalansicht vorteilhafterweise mittig angeordnet.

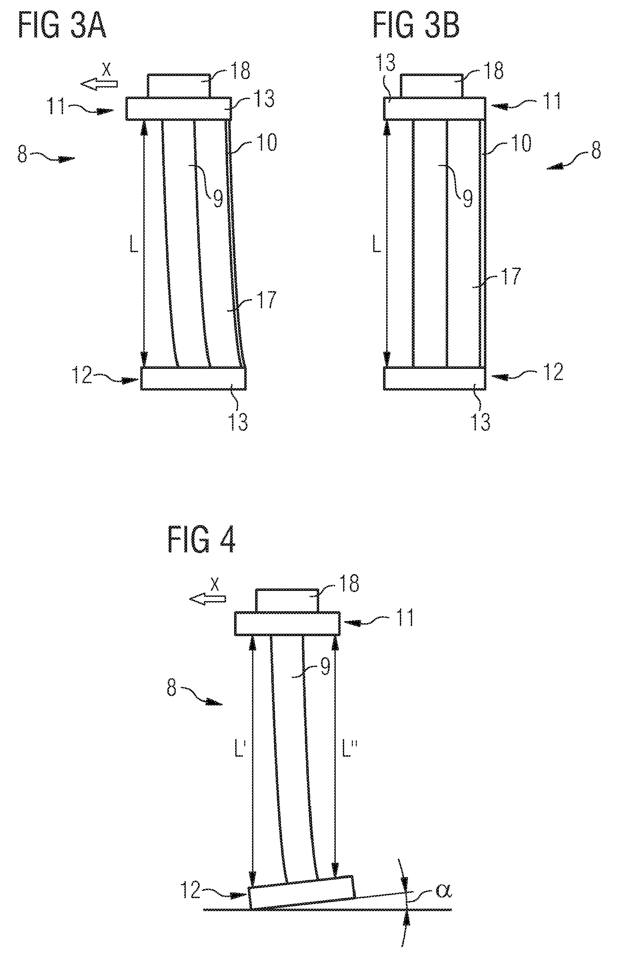

Der durch die Stabilisierungsstrebe 10 erzielte Effekt wird anhand der Figuren 3A und 3B näher erläutert.

In Figur 3A ist die Positioniereinrichtung 8 in einer Situation dargestellt, in der sie mittels des auf Seiten des Festlagers 11 angeordneten Antriebs 18 in der Bewegungsrichtung (Pfeil X) beschleunigt wird. Aufgrund der einseitig wirkenden Beschleunigungskraft und der Trägheitskräfte kommt es zu einer Verformung des Positionierarmes 9 und der Stabilisierungsstrebe 10. Die als Zug -Druckstab ausgebildete Stabilisierungsstrebe 10 bewirkt jedoch, dass der Abstand L zwischen den Linearführungen auf der Festlagerseite und der Stützlagerseite über die gesamte Länge der Führungswägen nahezu konstant bleibt. Mit anderen Worten bewirkt die Stabilisierungsstrebe 10, dass sich die Positioniereinrichtung 8 auf Seiten des losen Stützlagers 12 im Wesentlichen nur parallel zur geführten Festlagerseite in Bewegungsrichtung (Pfeil X) bewegen kann. Eine Drehung der losen Stützlager 12 um die geführte Festlagerseite in einer durch die Bewegungsrichtung (Pfeil X) und die Erstreckungsrichtung des Positionierarmes 9 bzw. der Stabilisierungsstrebe 10 definierten Ebene wird weitgehend verhindert. Durch diese zwangsweise Parallelstellung der beiden Lager der Positioniereinrichtung 8 wird erreicht, dass sich die Positioniereinrichtung 8 beim Erreichen der Zielposition (Fig. 3B) auf Seiten des Stützlagers 12 entsprechend nachstellt und nicht reproduzierbare Positionierungenauigkeiten aufgrund der Reibung zwischen der Stützrolle und der Führungsfläche 15 werden verhindert.

Zur weiteren Verdeutlichung des durch die Stabilisierungsstrebe 10 erreichten Effekts ist in Figur 4 dieselbe Situation wie in Figur 3A dargestellt, jedoch für eine Positioniereinrichtung 8 ohne Stabilisierungsstrebe 10. Bei einer einseitigen Beschleunigung der Positioniereinrichtung 8 verhält sich der Positionierarm 9 in diesem Fall wie ein Biegebalken, das heißt es kommt aufgrund der einseitigen Beschleunigungskraft und der Trägheitskräfte zu einer Drehung der Stützlagerseite um die Festlagerseite in einer durch die Bewegungsrichtung (Pfeil X) und die Erstreckungsrichtung des Trägerarmes definierten Ebene. Diese Drehung ist in Figur 4 durch den Winkel α dargestellt. Gleichbedeutend damit ist, dass der Abstand der Führungswägen L' und L" auf Seiten des Stützlagers 12 und auf Seiten des Führungslagers in ihrer Längserstreckung variiert. Aufgrund der Reibung der Stützrollen 16 auf Seiten des Stützlagers 12 stellt sich die Stützlagerseite bei Erreichen der Zielposition nie vollständig nach, so dass es zu nicht reproduzierbaren Positionierungsfehlern kommt. Mit anderen Worten, der Winkel α bleibt auf nicht reproduzierbare Weise bei Erreichen der Zielposition erhalten.

Die obige Beschreibung zeigt, dass mittels des erfindungsgemäßen Bestückautomaten 1 eine erheblich größere Bestückgenauigkeit erreicht werden kann. Um einen ähnlichen Effekt mit herkömmlichen Positioniersystemen ohne Stabilisierungsstrebe 10 zu erreichen, müsste der Positionierarm 9 eine wesentlich größer dimensionierten Querschnitt aufweisen und/oder es müssten teurere Spezialmaterialien für den Positionierarm 9 zum Einsatz kommen, wie beispielsweise kohlefaserverstärkter Kunststoff. Die vorliegende Konstruktion erlaubt jedoch einen wesentlich schlankeren, leichteren und kostengünstigeren Aufbau, sowie die Anordnung zweier Bestückköpfe 6, 7 an dem Positionierarm 9 in sehr engem Abstand, was die Verfahrwege beim Bestücken verkürzt und die Bestückleistung weiter erhöht.

## Patentansprüche

1. Bestückautomat (1) zum Bestücken von Substraten (4) mit elektrischen Bauelementen, mit einem Chassis (2) und einer Positioniereinrichtung (8) für einen Bestückkopf (6), wobei
- die Positioniereinrichtung (8) einen Positionierarm (9) und eine Stabilisierungsstrebe (10) aufweist, welche in einer Bewegungsrichtung gegenüber dem Chassis (2) bewegbar gelagert sind, sich quer zur Bewegungsrichtung erstrecken und in Bewegungsrichtung beabstandet sind,
- der Positionierarm (9) und die Stabilisierungsstrebe (10) auf gleichen Seiten jeweils im Bereich eines Endes durch ein Festlager (11) und jeweils im Bereich eines gegenüberliegenden anderen Endes durch ein loses Stützlager (12) gelagert sind, und
- die Stabilisierungsstrebe (10) und der Positionierarm (9) nur im Bereich ihrer Enden starr miteinander verbunden sind.

2. Bestückautomat (1) nach Anspruch 1, wobei zwischen dem Stabilisierungsstrebe (10) und dem Positionierarm (9) ein durchgehender Zwischenraum (17) ausgebildet ist und ein erster Bestückkopf (6) und ein zweiter Bestückkopf (7) am Positionierarm (9) derart vorgesehen sind, dass der erste Bestückkopf (6) entlang einer der Stabilisierungsstrebe (10) abgewandten Seite des Positionierarms (9) verschiebbar gelagert ist und der zweite Bestückkopf (7) entlang einer der Stabilisierungsstrebe (10) zugewandten Seite des Positionierarms (9) in dem Zwischenraum 17 verschiebbar gelagert ist.

3. Bestückautomat (1) nach einem der Ansprüche 1 bis 2, wobei die Stabilisierungsstrebe (10) in einer zur Bewegungsrichtung parallelen Frontalansicht bezüglich des Positionierarms (9) mittig angeordnet ist.
